# EUROPEAN PATENT APPLICATION

(11) **EP 2 509 123 A2**
(43) Date of publication of application: **10.10.2012**
(21) Application number: 12161162.8
(22) Date of filing: 26.03.2012
(51) Int. Cl.: H01L 35/30

(54) **Thermoelectric conversion module**

(30) Priority: 07.04.2011 JP 2011085835
(71) Applicant: Kabushiki Kaisha Toyota Jidoshokki, Kariya-shi, Aichi 448-8671 (JP)
(72) Inventor: Morisaku, Naoto, Kariya-shi, Aichi 448-8671 (JP); Akiyama, Hirokuni, Kariya-shi, Aichi 448-8671 (JP); Tanaka, Toshimitsu, Kariya-shi, Aichi 448-8671 (JP); Mune, Shimpei, Kariya-shi, Aichi 448-8671 (JP)
(74) Representative: TBK

(57) **Abstract**

A thermoelectric conversion module includes two substrates, electrodes, thermoelectric conversion elements provided between the substrates and electrically connected in series via the electrodes, a polygonally-shaped thermoelectric conversion element disposition area provided on inner surface of the substrate wherein the thermoelectric conversion elements are disposed in the thermoelectric conversion element area, a fin radiator provided on outer surface of the substrate and a fin disposition area wherein the fin radiator is disposed in the fin disposition area. The fin disposition area and the thermoelectric conversion element disposition area are located on opposite sides of the substrates so as to overlap each other via the substrate. Part of each of the thermoelectric conversion elements located at least one corner of the thermoelectric conversion element disposition area is located outside the fin disposition area when the fin disposition area is projected on the thermoelectric conversion element disposition area.

## Description

### BACKGROUND OF THE INVENTION

The present invention relates to a thermoelectric conversion module.

Referring to FIG. 1, there is shown a thermoelectric conversion module disclosed by Japanese Patent Application Publication 2002-111079. The thermoelectric conversion module includes a first substrate 91 having an inner surface 91A and an outer surface 91B, and a second substrate 92 having an inner surface 92A facing the inner surface 91A of the first substrate 91 and an outer surface 92B facing away from the outer surface 91B of the first substrate 91, The thermoelectric conversion module further includes a plurality of electrodes 93A, 93B provided on the respective inner surfaces 91A, 92A of the first and the second substrates 91, 92 and a plurality of thermoelectric conversion elements 94 that are connected in series via the electrodes 93A, 93B. The thermoelectric conversion elements 94 that are disposed between the first substrate 91 and the second substrate 92 form rectangular thermoelectric conversion disposition areas on the respective inner surfaces 91A, 92A.

The thermoelectric conversion module is operable to switch between the heat absorption and the heat release in a complementary manner on the opposite first substrate 91 side and the second substrate 92 side of the thermoelectric conversion module due to the Peltier effect generated by the thermoelectric conversion element 94. This kind of thermoelectric conversion module is used as a device for cooling and heating of heat exchange medium in a vehicle air conditioner by utilizing the heat transfer between the first substrate 91 side and the second substrate 92 side of the thermoelectric conversion module. The thermoelectric conversion module is also operable to generate electric power by the conversion of temperature difference into electricity according to the Seebeck effect.

In such thermoelectric conversion module, a first fin-type radiator 95 and a second fin-type radiator 96 can be mounted on the outer surfaces 91B, 92B of the respective first and the second substrates 91, 92 by brazing so as to improve heat absorption, heat release and heat reception. For this purpose, the fins of the first and the second fin-type radiators 95, 96 are made of a metal having a high heat conductivity.

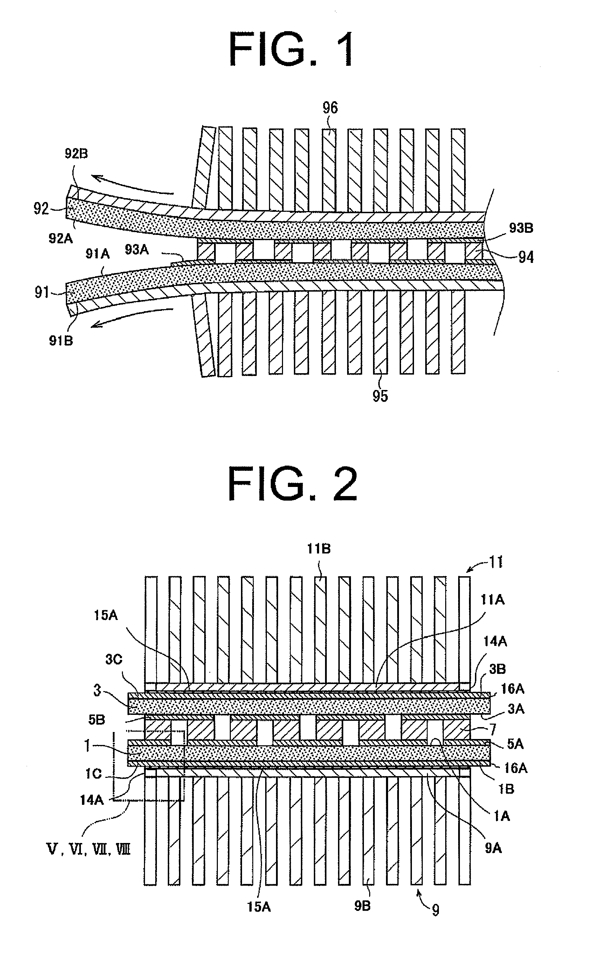

However, when the radiators 95, 96 are brazed to the first and the second substrates 91, 92 in the manufacture of the thermoelectric conversion module, the first and the second substrates 91, 92 are deformed by heat as indicated by arrows in FIG. 1, so that the thermoelectric conversion elements 94 tend to be damaged by the deformation of the first and the second substrates 91, 92 and the serviceable life of the thermoelectric conversion module is reduced, accordingly.

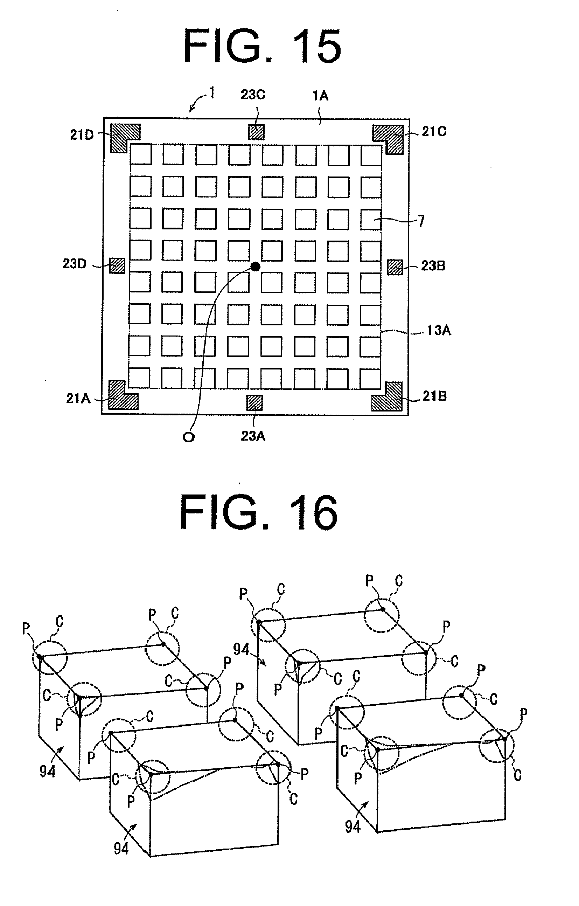

The stress simulation analysis conducted by the present inventors shows that a stress that is great enough to cause damage to the thermoelectric conversion element 94 is applied to an area (indicated by dashed-dotted line in FIG. 16) around an apex P of a corner C of the thermoelectric conversion element 94. The corner C of the thermoelectric conversion element 94 means an area around the apex P.

The present invention is directed to providing a thermoelectric conversion module having a long serviceable life.

### SUMMARY OF THE INVENTION

A thermoelectric conversion module includes two substrates, electrodes, thermoelectric conversion elements provided between the substrates and electrically connected in series via the electrodes, a polygonally-shaped thermoelectric conversion element disposition area provided on inner surface of the substrate wherein the thermoelectric conversion elements are disposed in the thermoelectric conversion element area, a fin radiator provided on outer surface of the substrate and a fin disposition area wherein the fin radiator is disposed in the fin disposition area. The fin disposition area and the thermoelectric conversion element disposition area are located on opposite sides of the substrates so as to overlap each other via the substrate. Part of each of the thermoelectric conversion elements located at least one corner of the thermoelectric conversion element disposition area is located outside the fin disposition area when the fin disposition area is projected on the thermoelectric conversion element disposition area.

A thermoelectric conversion module includes two substrates, electrodes, thermoelectric conversion elements provided between the substrates, a thermoelectric conversion element disposition area wherein the thermoelectric conversion elements are disposed in the thermoelectric conversion element area, a fin radiator provided on the substrate, a junction material layer disposed between the fin radiator and the substrate and a junction material layer disposition area wherein the junction material layer is disposed in the junction material layer disposition area. The junction material layer disposition area and the thermoelectric conversion element area are located on opposite sides of the substrates so as to overlap each other via the substrate. Part of each of the thermoelectric conversion elements located at least one corner of the thermoelectric conversion element disposition area is located outside the junction material layer disposition area when the junction material layer disposition area is projected on the thermoelectric conversion element disposition area.

A thermoelectric conversion module includes two substrates, electrodes, thermoelectric conversion elements provided between the substrates and electrically connected in series via the electrodes, a thermoelectric conversion element disposition area provided on inner surface of the substrate wherein the thermoelectric conversion elements are disposed in the thermoelectric conversion element area and a fin radiator provided on the substrate. The fin radiator includes a base extending in parallel to outer surface of the substrate and a plurality of plates extending outward from the outer surface. The base and the outer surface of the substrate cooperate to form a space at a position corresponding to at least one of corners of the thermoelectric conversion element disposition area.

A thermoelectric conversion module includes two substrates, electrodes, thermoelectric conversion elements provided between the substrates and electrically connected in series via the electrodes and a polygonally-shaped thermoelectric conversion element disposition area provided on inner surface of the substrate wherein the thermoelectric conversion elements are disposed in the thermoelectric conversion element area. Each inner angle of all corners of the thermoelectric conversion element disposition area is more than 90°.

A thermoelectric conversion module includes two substrates, electrodes, thermoelectric conversion elements provided between the substrates and electrically connected in series via the electrodes, a polygonally-shaped thermoelectric conversion element disposition area provided on inner surface of the substrate wherein the thermoelectric conversion elements are disposed in the thermoelectric conversion element area and a plurality of column members. The column members are provided between the substrates at positions that are outward of the thermoelectric conversion element disposition area and joined to the substrates.

Other aspects and advantages of the invention will become apparent from the following description, taken in conjunction with the accompanying drawings, illustrating by way of example the principles of the invention.

### BRIEF DESCRIPTION OF THE DRAWINGS

The features of the present invention that are believed to be novel are set forth with particularity in the appended claims. The invention together with objects and advantages thereof, may best be understood by reference to the following description of the presently preferred embodiments together with the accompanying drawings in which:
FIG. 1 is a CAE analysis sectional view of a thermoelectric conversion module according to a prior art;
FIG. 2 is a sectional view of a thermoelectric conversion module according to a first embodiment of the present invention;
FIG. 3 is a plan view showing a first inner surface of a first substrate of the thermoelectric conversion module of FIG. 2;
FIG. 4 is a plan view showing a first outer surface of the first substrate of the thermoelectric conversion module of FIG. 2;
FIG. 5A is a partially enlarged schematic sectional view showing a part of the thermoelectric conversion module that is surrounded by a box indicated by chain and double-dashed line in FIG. 2;
FIG. 5B is a schematic plan view of a fin disposition area, a joining layer and a metal layer of the thermoelectric conversion module of FIG. 2, wherein the area and the layers are shown separated slightly from each other in vertical direction for ease of understanding;
FIG. 6A is a partially enlarged schematic sectional view similar to that of FIG. 5A, showing a thermoelectric conversion module according to a second embodiment of the present invention;
FIG. 6B is a schematic plan view of a fin disposition area, a joining layer and a metal layer of the thermoelectric conversion module of FIG. 6A, wherein the area and the layers are shown separated slightly from each other in vertical direction;
FIG. 7A is a partially enlarged schematic sectional view similar to that of FIG. 5A, showing a thermoelectric conversion module according to a third embodiment of the present invention;
FIG. 7B is a schematic plan view of a fin disposition area, a joining layer and a metal layer of the thermoelectric conversion module of FIG. 7A, wherein the area and the layers are shown separated slightly from each other in vertical direction;
FIG. 8A is a partially enlarged schematic sectional view similar to that of FIG. 5A, showing a thermoelectric conversion module according to a fourth embodiment of the present invention;
FIG. 8B is a schematic plan view of a fin disposition area, a joining layer and a metal layer of the thermoelectric conversion module of FIG. 8A, wherein the area and the layers are shown separated slightly from each other in vertical direction;
FIG. 9 is a sectional view of a thermoelectric conversion module according to a fifth embodiment of the present invention;
FIG. 10 is a plan view showing a first inner surface of a first substrate of the thermoelectric conversion module of FIG. 9;
FIG. 11 is a plan view showing a first outer surface of the first substrate of the thermoelectric conversion module of FIG. 10;
FIG. 12 is a plan view showing a first inner surface of a first substrate of a thermoelectric conversion module according to a sixth embodiment of the present invention;
FIG. 13 is a sectional view of a thermoelectric conversion module according to a seventh embodiment of the present invention;
FIG. 14 is a plan view showing a first inner surface of a first substrate of the thermoelectric conversion module of FIG. 13;
FIG. 15 is a plan view showing a first inner surface of a first substrate of the thermoelectric conversion module of FIG. 13; and
FIG. 16 is a schematic view for explaining stress distribution of thermoelectric conversion elements of the thermo electric conversion module of FIG. 1.

### DETAILED DESCRIPTION OF THE PREFERRED EMBODIMENTS

The following will describe the first through the eighth embodiments of the present invention with reference to the accompanying drawings.

Firstly referring to FIG. 2, the thermoelectric conversion module according to the first embodiment includes a first substrate 1, a second substrate 3, a plurality of electrodes 5A, 5B, a plurality of thermoelectric conversion elements 7, a first fin radiator 9 and a second fin radiator 11.

The first and the second substrates 1, 3 are provided in the form of a square plate made of aluminum nitride. The electrodes 5A, 5B are made of an aluminum plate and joined to a first and a second inner surfaces 1A, 3A of the first and the second substrates 1, 3 by brazing, respectively.

A junction material disposition area 16A is provided on a first and a second outer surfaces 1B, 3B of the respective first and the second substrates 1, 3 and an aluminum plate having the same shape as the first and the second substrates 1, 3 as viewed from the top is joined to the junction material disposition area 16A by brazing. The above aluminum plates form metal layers 1C, 3C. The first and the second fin radiators 9, 11 are joined to the metal layers 1C, 3C, respectively, as will be described later. The first and the second substrates 1, 3 correspond to the identified substrates of the present invention.

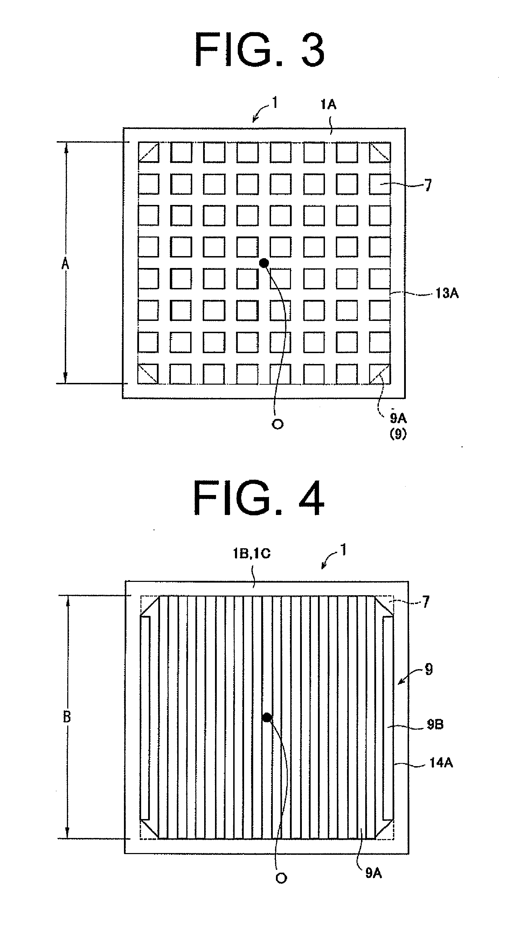

Referring to FIG. 3, reference symbol 13A designates a thermoelectric conversion element disposition area where the thermoelectric conversion elements 7 are disposed. The thermoelectric conversion element disposition area 13A is provided on the center of the first inner surface 1A of the first substrate 1. As shown in FIG. 1, the thermoelectric conversion element disposition area 13A is of a square shape having a dimension A for each side. Though not shown in FIG. 3, the electrodes 5A are disposed in the thermoelectric conversion element disposition area 13A. A similar thermoelectric conversion element disposition area 13A is provided on the center of the second inner surface 3A of the second substrate 3 and the electrodes 5B (not shown in FIG. 3) are disposed in the thermoelectric conversion element disposition area 13A. The thermoelectric conversion element disposition area 13A according to the present invention is of a polygonal shape that is formed by connecting the outermost peripheral portions of those thermoelectric conversion elements 7 which are located in the outermost region of the thermoelectric conversion element disposition area. Accordingly, a corner of the thermoelectric conversion element disposition area refers to a corner of the polygonal area.

The thermoelectric conversion element 7 is made of bismuth-tellurium alloys and formed by a known p-type thermoelectric conversion element and a known n-type thermoelectric conversion element. Each thermoelectric conversion element 7 has a rectangular column shape and the opposite end surfaces thereof have a rectangular shape. The opposite end surfaces of the thermoelectric conversion element 7 are joined to the electrodes 5A, 5B of the first and the second substrates 1, 3, respectively by soldering. The p-type thermoelectric conversion elements and the n-type thermoelectric conversion elements are disposed within the thermoelectric conversion element disposition area 13A in a lattice arrangement and the thermoelectric conversion elements 7 are electrically connected in series via the electrodes 5A, 5B of the respective first and the second substrates 1, 3. Thus, the thermoelectric conversion elements 7 are thermally connected in parallel to each other between the first and the second substrates 1, 3.

Referring to FIG. 4, the first fin radiator 9 includes a base 9A made of an octagonal-shaped aluminum plate and a plurality of plates 9B made of aluminum and extending vertically outward from the base 9A. The base 9A and the plates 9B are joined to each other by brazing. As shown in FIG. 4, the first fin radiator 9 is of an octagonal shape and all the aluminum plates 98 are located within the outer periphery of the first fin radiator 9 as seen in the plan view. The dimension B of the base 9A, or of the plates 9B except the two short plates 9B located on the opposite sides of the base 9A, as measured in the extension of the plates as seen in plan view in FIG. 4 is substantially the same as the dimension A mentioned with reference to FIG. 3. The second fin radiator 11 shown in FIG. 2 has substantially the same structure as the first fin radiator 9.

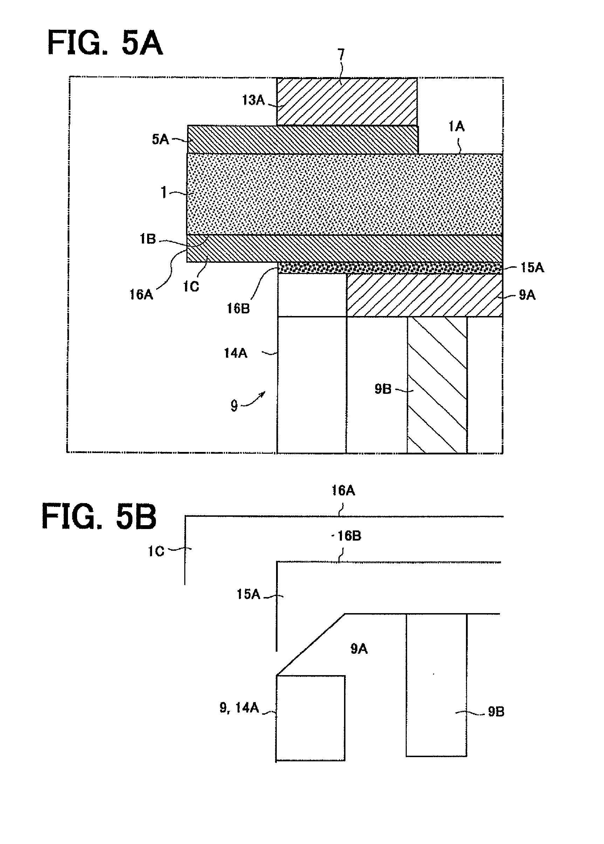

Referring to FIGS. 5A and 5B, reference symbol 14A designates a fin disposition area where the first fin radiator 9 is disposed. The fin disposition area 14A is provided on the outer surface of the metal layer 1C in such a way that the center O of the fin disposition area 14A coincides with that of the thermoelectric conversion element disposition area 13A in the thickness direction of the first substrate 1 (refer to FIGS. 3, 4). In other words, the fin disposition area 14A and the thermoelectric conversion element disposition area 13A are located on the opposite sides of the first substrate 1 so as to overlap each other via the first substrate 1. The fin disposition area 14A has the same octagonal shape as the base 9A of the first fin radiator 9.

A square-shaped brazing filler metal sheet that forms a brazing filler metal layer 15A is disposed between the metal layer 1C and the base 9A of the first fin radiator 9. The brazing filler metal layer 15A and the metal layers 1C, 3C serves as the junction material layer of the present invention. The brazing filler metal layer 15A is disposed in the junction material disposition area 16B lying on the metal layer 1C in such a way that the center of the junction material disposition area 16B coincides with that of the fin disposition area 14A. The junction material disposition area 16B has the same square shape as the brazing filler metal layer 15A. Only the junction material disposition area 16B that is provided on the first substrate 1 side is shown in FIG. 5.

The first substrate 1 is thermally joined to the first fin radiator 9 by brazing the metal layer 1C to the base 9A of the first fin radiator 9 through the brazing filler metal layer 15A. The same is true of the metal layer 3C and the second fin radiator 11.

In the above structure of the thermoelectric conversion module, the outer surfaces of the first and the second substrates 1, 3 are enlarged by the addition of the first and the second fin radiators 9, 11, so that the heat absorption and release of the thermoelectric conversion module is improved.

As described above, the base 9A of the first fin radiator 9 has an octagonal shape, so that the fin disposition area 14A has also an octagonal shape. On the other hand, the thermoelectric conversion element disposition area 13A and the metal layer 1C have the same square shape. Therefore, the first fin radiator 9 is joined to the metal layer 1C in such a way that part of each of the thermoelectric conversion elements 7 located at four corners of the square-shaped thermoelectric conversion element disposition area 13A are located outside the fin disposition area 14A when the fin disposition area 14A is projected on the thermoelectric conversion element disposition area 13A, as shown in FIG. 3. As a result of such arrangement, the thermoelectric conversion elements 7 located at the respective corners of the thermoelectric conversion element disposition area 13A are hardly affected by the stress caused by thermal deformation of the first substrate 1 and the first fin radiator 9. The same is true of the second substrate 3 side where the second fin radiator 11 is joined. Therefore, any stress applied to the thermoelectric conversion elements 7 at the respective corners of the thermoelectric conversion element disposition area 13A when the first and the second substrates 1, 3 are thermally deformed due to the thermal deformation of the first and the second fin radiators 9, 11 is reduced.

Thus, the thermoelectric conversion elements 7 of the thermoelectric conversion module according to the first embodiment are hardly damaged but has a long serviceable life. The thermoelectric conversion module also offers a good performance due to the cooling effect by the addition of the first and the second fin radiators 9, 11.

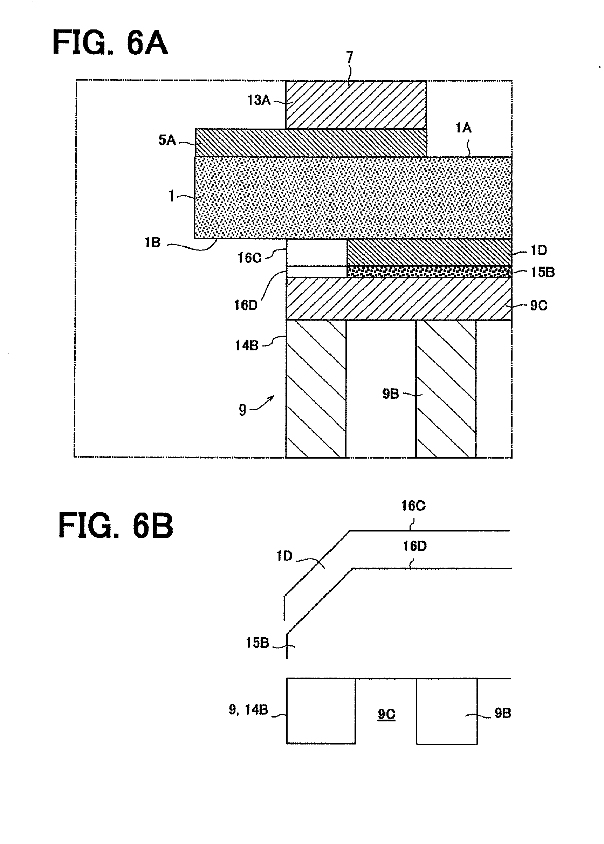

In the thermoelectric conversion module according to the second embodiment shown in FIGS. 6A and 6B, etching is applied to the metal layer 1D that is made of an aluminum and joined to the first outer surface 1B of the first substrate 1. The metal layer 1D has originally the same outer shape as the first substrate 1 but is formed into an octagonal shape after the etching. The metal layer 1D serves as the junction material layer of the present invention. The junction material disposition area 16C where the metal layer 1D is disposed is provided on the first outer surface 1B of the first substrate 1 in such a way that the center O of the junction material disposition area 16C coincides with that of the thermoelectric conversion element disposition area 13A in the thickness direction of the first substrate 1. In other words, the junction material disposition area 16C and the thermoelectric conversion element disposition area 13A are located on the opposite sides of the first substrate 1 so as to overlap each other via the first substrate 1. The same is true of the second outer surface 3B of the second substrate 3 side of the thermoelectric conversion module.

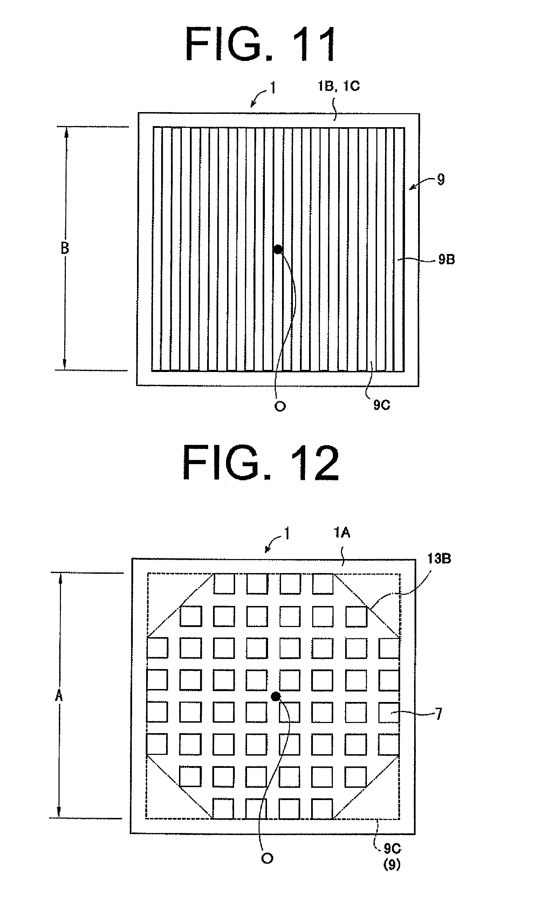

The base 9A of first fin radiator 9 has the same square shape as the thermoelectric conversion element disposition area 13A and the first fin radiator 9 includes a plurality of plates 9B (refer to FIG. 11). That is, first fin radiator 9 is square-shaped in the plan view. The first fin radiator 9 is disposed in the fin disposition area 14B. The same is true of the second fin radiator 11.

As shown in FIG. 6A, the fin disposition area 14B is provided on the outer surface of the metal layer 1D in such a way that the center of the fin disposition area 14B coincides with that of the thermoelectric conversion element disposition area 13A in the thickness direction of the first substrate 1 (refer to FIGS. 3, 4). The fin disposition area 14B has the same square shape as the base 9C of the first fin radiator 9.

As shown in FIG. 6A, an octagonal-shaped brazing filler metal sheet forming a brazing filler metal layer 15B is disposed between the metal layer 1D and the base 9C of the first fin radiator 9. The brazing filler metal layer 15B serves as the junction material layer as well as the metal layer 1D. The brazing filler metal layer 15B is disposed in the junction material disposition area 16D provided on the metal layer 1D in such a way that the center of the junction material disposition area 16D coincides with that of the fin disposition area 14B. The junction material disposition area 16C has the same octagonal shape as the brazing filler metal layer 15B and the metal layer 1D (refer to FIG. 6B).

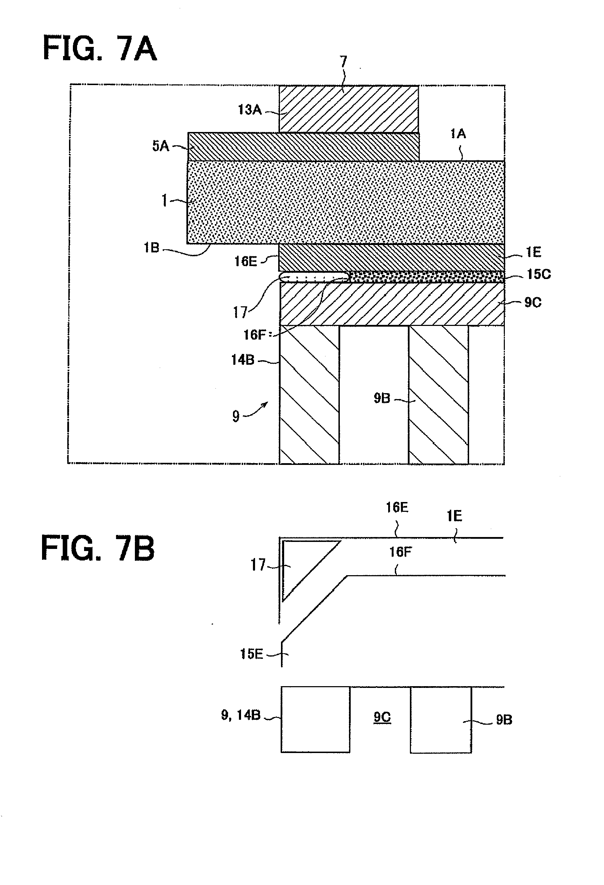

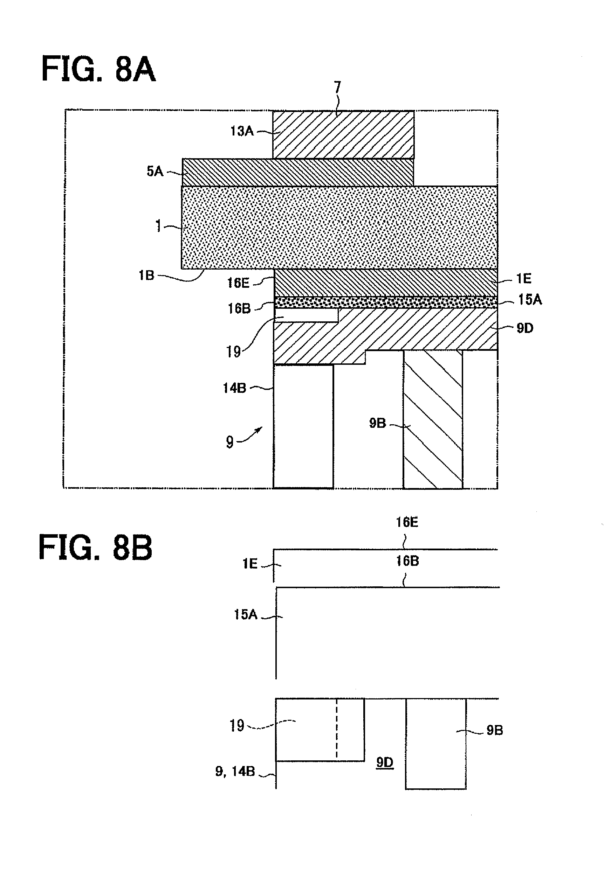

The first substrate 1 is thermally joined to the first fin radiator 9 by brazing the metal layer 1D to the base 9C of the first fin radiator 9 through the brazing filler metal layer 15B. The same is true of the second substrate 3. In the following of FIGS. 6A and 6B, the metal layer 1D, the brazing filler metal layer 15B, the junction material disposition areas 16C, 16D and the fin disposition area 14B for the first substrate 1 side will be described. The same is true of the third and the fourth embodiments shown in FIGS. 7A, 7B, 8A and 8B. The rest of the structure is the same as that of the thermoelectric conversion module according to the first embodiment. The same reference numerals denote components or elements that are similar to the counterparts of the first embodiment and the description thereof will be omitted.

In the thermoelectric conversion module according to the second embodiment, the metal layer 1D disposed in the junction material disposition area 16C has the same octagonal shape as the brazing filler metal layer 15B disposed in the junction material disposition area 16D. Therefore, the metal layer 1D and the brazing filler metal layer 15B are absent at positions corresponding to the four corners of the thermoelectric conversion element disposition area 13A, so that the first fin radiator 9 is not joined to the first outer surface 1B of the first substrate 1 at the respective corners of the thermoelectric conversion element disposition area 13A. Therefore, when the junction material disposition areas 16C, 16D are projected on the thermoelectric conversion element disposition area 13A, the thermoelectric conversion elements 7 that are located at the respective corners of the thermoelectric conversion element disposition area 13A and also outside of the junction material disposition areas 16C, 16D hardly receive the stress caused by the thermal deformation of the first substrate 1 and the first fin radiator 9. The same is true of the second substrate 3 where the second fin radiator 11 is joined. Thus, any stress that is caused to the thermoelectric conversion elements 7 at the respective corners of the thermoelectric conversion element disposition area 13A by the thermal deformation of the first and the second substrates 1, 3 is reduced, so that the thermoelectric conversion elements 7 are hardly damaged. The second embodiment offers also the advantages that are described with reference to the first embodiment.

In the thermoelectric conversion module according to the third embodiment shown in FIGS. 7A and 7B, a square-shaped aluminum plate made by stamping is fixed by brazing to the first outer surface 1B of the first substrate 1 thereby to form a metal layer 1 E. The metal layer 1 E has the same square shape as the thermoelectric conversion element disposition area 13A. The metal layer 1 E serves as the junction material layer of the present invention. The junction material disposition area 16E where the metal layer 1 E is disposed is provided on the first outer surface 1B of the first substrate 1 in such a way that the center O of the junction material disposition area 16E coincides with that of the thermoelectric conversion element disposition area 13A in the thickness direction of the first substrate 1. In other words, the junction material disposition area 16E is located on the opposite side of the first substrate 1 from the thermoelectric conversion element disposition area 13A. The junction material disposition area 16E and the thermoelectric conversion element disposition area 13A overlap each other when the junction material disposition area 16E is projected on the thermoelectric conversion element disposition area 13A. The same is true of the second outer surface 3B side of the second substrate 3.

The fin disposition area 14B is provided on the outer surface of the metal layer 1 E in such a way that the center of the fin disposition area 14B coincides with that of the thermoelectric conversion element disposition area 13A in the thickness direction of the first substrate 1 (refer to FIGS. 3, 4). The fin disposition area 14B has the same square shape as the base 9C of the first fin radiator 9.

As shown in FIG. 7A, a brazing filler metal sheet forming the brazing filler metal layer 15C is disposed between the metal layer 1E and the base 9C of the first fin radiator 9. The brazing filler metal layer 15C serves as the junction material layer as well as the metal layer 1 E. The brazing filler metal layer 15C is disposed in the junction material disposition area 16F that is provided on the metal layer 1 E.

A masking 17 is provided at each corner of the outer surface of the metal layer 1E forming the junction material disposition area 16F for preventing the metal layer 1 E from being brazed to the base 9C and, therefore, the brazing filler metal layer 15C has an octagonal shape. Accordingly, the junction material disposition area 16F has the same octagonal shape as the brazing filler metal layer 15C (refer to FIG. 7B).

The first substrate 1 is thermally joined to the first fin radiator 9 by brazing the metal layer 1E to the base 9C of the first fin radiator 9 through the brazing filler metal layer 15C. The masking 17 may be provided only at one corner of the outer surface of the metal layer 1 E. The same is true of the structure of the second substrate 3 side. The rest of the structure is substantially the same as that of the thermoelectric conversion element according to the first and the second embodiments.

In the thermoelectric conversion element according to the third embodiment, the brazing filler metal layer 15C has an octagonal shape in the plan view, so that the junction material disposition area 16F has the same octagonal shape as the brazing filler metal layer 15C. The masking 17 is provided outward of the junction material disposition area 16F on the outer surface of the metal layer 1 E between the metal layer 1E and the corresponding corners of the base 9C at the corners thereof. Therefore, the metal layer 1 E and the base 9C are not joined each other at position corresponding to the corners of the metal layer 1 E and the base 9C. As described above, the metal layer 1 E has the same square shape as the thermoelectric conversion element disposition area 13A and is disposed in the first substrate 1 in such a way that the center of the metal layer 1 E coincides with that of the thermoelectric conversion element disposition area 13A, so that each masking 17 is disposed below the thermoelectric conversion element 7 at positions corresponding to four corners of the thermoelectric conversion element disposition area 13A. On the other hand, each masking 17 on the second substrate 3 side of the thermoelectric conversion module is disposed above the thermoelectric conversion element 7 at positions corresponding to four corners of the thermoelectric conversion element disposition area 13A.

Thus, the stress that is caused by thermal deformation of the first substrate 1 and the first fin radiator 9 hardly act on the position where the first fin radiator 9 is not joined to the metal layer 1 E due to the presence of the masking 17. Therefore, the thermoelectric conversion elements 7 located at positions corresponding to the respective corners of the thermoelectric conversion element disposition area 13A where the first fin radiator 9 is not joined to the metal layer 1 E hardly receive the stress caused by the thermal deformation of the first substrate 1 and the first fin radiator 9. The same is true of the second substrate 3 side of the thermoelectric conversion module where the second fin radiator 11 is joined. Thus, the stress that is caused by the thermal deformation of the first and the second substrates 1, 3 and applied to the thermoelectric conversion elements 7 located at the respective corners of the thermoelectric conversion element disposition area 13A is reduced, so that the thermoelectric conversion elements 7 are hardly damaged. The third embodiment offers also the advantages that are described with reference to the first embodiment.

In the thermoelectric conversion module according to the fourth embodiment shown in FIGS. 8A and 8B, the junction material disposition area 16E is provided on the first outer surface 1B of the first substrate 1 and the metal layer 1E is disposed in the junction material disposition area 16E as is the case of the third embodiment. The same is true of the second outer surface 3B of the second substrate 3.

As is the case of the second and the third embodiments, the fin disposition area 14B is provided on the outer surface of the metal layer 1 E in such a way that the center of the fin disposition area 14B coincides with that of the thermoelectric conversion element disposition area 13A in the thickness direction of the first substrate 1 (refer to FIGS. 3, 4). Additionally, as is the case of the first embodiment, the junction material disposition area 16B is provided on the outer surface of the metal layer 1 E and the brazing filler metal layer 15A is provided in the junction material disposition area 16B. The brazing filler metal layer 15A and the metal layer 1 E serves as the junction material layer of the present invention. The same is true of the second outer surface 3B side of the second substrate 3. The rest of the structure is substantially the same as that of the thermoelectric conversion module according to the first embodiment.

The first fin radiator 9 includes the base 9D having the same square shape as the thermoelectric conversion element disposition area 13A and the plurality of aluminum plates 9B. Each corner of the base 9D is shaped so as to form a space 19 between each corner of the brazing filler metal layer 15A and the corresponding corner of the base 9D, as shown in FIG. 8. The same is true of the second fin radiator 11 side of the thermoelectric conversion module. The space 19 may be formed only at one corner of the base 9D.

In the thermoelectric conversion module according to the fourth embodiment, the base 9D is not joined to the metal layer 1 E at the corners of the brazing filler metal layer 15A on the metal layer 1 E and of the base 9D due to the presence of the respective spaces 19. As described above, the metal layer 1E and the base 9D have the same square shape as the thermoelectric conversion element disposition area 13A and are disposed in such a way that the center thereof coincides with that of the thermoelectric conversion element disposition area 13A in the thickness direction of the first substrate 1. Therefore, each space 19 is located below the thermoelectric conversion element 7 that is located at a corner of the thermoelectric conversion element disposition area 13A. Similarly, each space 19 on the second substrate 3 side of the thermoelectric conversion module is located above the thermoelectric conversion element 7 that is disposed at a corner of the thermoelectric conversion element disposition area 13A.

Therefore, the thermoelectric conversion elements 7 located at the respective corners of the thermoelectric conversion element disposition area 13A hardly receive the stress caused by thermal deformation of the first substrate 1 and the first fin radiator 9 by virtue of the spaces 19 where the first fin radiator 9 is not joined to the metal layer 1 E. The same is true of the second substrate 3 of the thermoelectric conversion module where the second fin radiator 11 is joined. Thus, the stress that is caused by the thermal deformation of the first and the second substrates 1, 3 and applied to the thermoelectric conversion elements 7 located at the respective corners of the thermoelectric conversion element disposition area 13A is reduced, so that the thermoelectric conversion elements 7 are hardly damaged. The fourth embodiment offers also the advantages that are described with reference to the first embodiment.

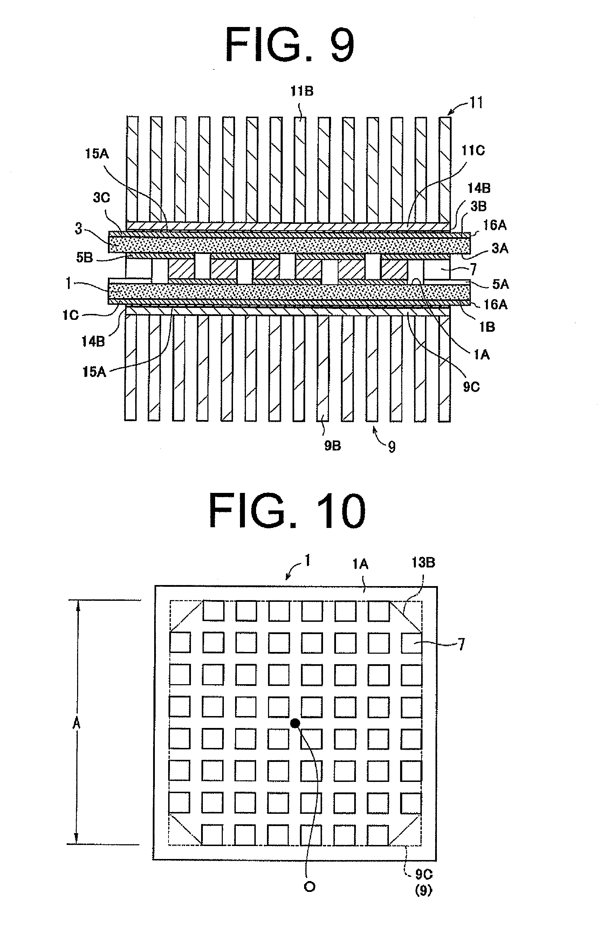

In the thermoelectric conversion module according to the fifth embodiment shown in FIGS. 9, 10 and 11, the thermoelectric conversion elements 7 that are disposed in the octagonal-shaped thermoelectric conversion element disposition areas 13B on the first and the second inner surfaces 1A, 3A of the square-shaped first and the second substrates 1, 3, respectively. The center O of the thermoelectric conversion element disposition area 13B coincides with that of the first and the second substrates 1, 3. The thermoelectric conversion element disposition area 13B is provided on the center of the first and the second substrates 1, 3. The electrodes 5A, 5B are provided on the first and the second inner surfaces 1A, 3A of the first and the second substrates 1, 3 so as to connect the thermoelectric conversion elements 7 in series via the electrodes 5A, 5B (refer to FIG. 9).

As shown in FIG. 11, the first fin radiator 9 includes the square-shaped base 9C and the plurality of plates 9B. Similarly, the second fin radiator 11 shown in FIG. 9 includes the square-shaped base 11C and the plurality of plates 11B.

As shown in FIG. 10, the thermoelectric conversion element disposition area 13B is of an octagonal shape, so that the inner angle of all the corners of the thermoelectric conversion element disposition area 13B is more than 90° but substantially 135°. Additionally, the dimension A of a side of the thermoelectric conversion element disposition area 13B (FIG. 10) is substantially the same as the dimension B of a side of the base 9C (FIG. 11).

As is the case of the second embodiment, the fin disposition area 14B where the first fin radiator 9 is disposed is located in such a way that the center of the fin disposition area 14B coincides with that of the thermoelectric conversion element disposition area 13B in the thickness direction of the first substrate 1, as shown in FIG. 9. Similarly, the fin disposition area 14B where the second fin radiator 11 is disposed is provided on the outer surface of the metal layer 3C.

As shown in FIG. 9, the brazing filler metal layer 15A is provided between the metal layer 1C and the base 9C. The brazing filler metal layer 15A and the metal layers 1C, 3C serve as the junction material layer of the present invention. The rest of the structure including the positional relation between the junction material disposition area 16A where the metal layers 1C, 3C are disposed and the junction material disposition area 16B (not shown in FIG. 9) where the brazing filler metal layer 15A is disposed is the same as the first embodiment.

In the thermoelectric conversion module shown in FIG. 10, the thermoelectric conversion elements 7 are disposed in the octagonal thermoelectric conversion element disposition area 13B between the first substrate 1 and the second substrate 3. The stress caused by thermal deformation of the first and the second substrates 1, 3 and the first and the second fin radiators 9, 11 increases at the corners of the square-shaped first and the second substrates 1, 3 and the bases 9C, 11G of the first and the second fin radiators 9, 11. In the thermoelectric conversion module according to the fifth embodiment, however, no thermoelectric conversion element 7 is disposed at the corners of the first and the second substrates 1, 3 corresponding to the corners of the bases 9C, 11C. Therefore, the thermoelectric conversion elements 7 of the thermoelectric conversion module according to the fifth embodiment are hardly damaged by the stress caused by the thermal deformation, so that Peltier effect and Seebeck effect of the thermoelectric conversion module are improved as compared with a case where the thermoelectric conversion elements are disposed at the corners of the first and the second substrates. The fifth embodiment offers also the advantages that are described with reference to the first embodiment. In the thermoelectric conversion module according to the fifth embodiment, the thermoelectric conversion element disposition areas 13B has an octagonal shape but may have a polygonal shape having five corners (or a pentagon shape) or more. Additionally, the fin disposition area 14B has a square shape but may have a rectangular shape.

Therefore, the thermoelectric conversion module according to the fifth embodiment has a long serviceable life and a good performance.

In the thermoelectric conversion module according to the sixth embodiment shown in FIG. 12, the thermoelectric conversion elements 7 are disposed in the thermoelectric conversion element disposition area 13B that is of an octagonal shape that is closer to a regular octagonal shape than that of the thermoelectric conversion element disposition area 13B in the fifth embodiment. The electrodes 5A, 5B are provided on the first and the second inner surfaces 1A, 3A of the first and the second substrates 1, 3 so as to connect the thermoelectric conversion elements 7 in series via the electrodes 5A, 5B. The rest of the structure is substantially the same as the thermoelectric conversion module according to the first and the fifth embodiments.

In the thermoelectric conversion module according to the sixth embodiment wherein the thermoelectric conversion elements 7 are disposed in the thermoelectric conversion element disposition area 13B of an octagonal shape that is closer to a regular octagonal shape than in the fifth embodiment, the area where no thermoelectric conversion element 7 is enlarged. Therefore, protection of the thermoelectric conversion elements 7 against damage by the stress due to the thermal deformation can be accomplished more effectively than in the fifth embodiment. The sixth embodiment offers also the advantages that are described with reference to the first and the fifth embodiments.

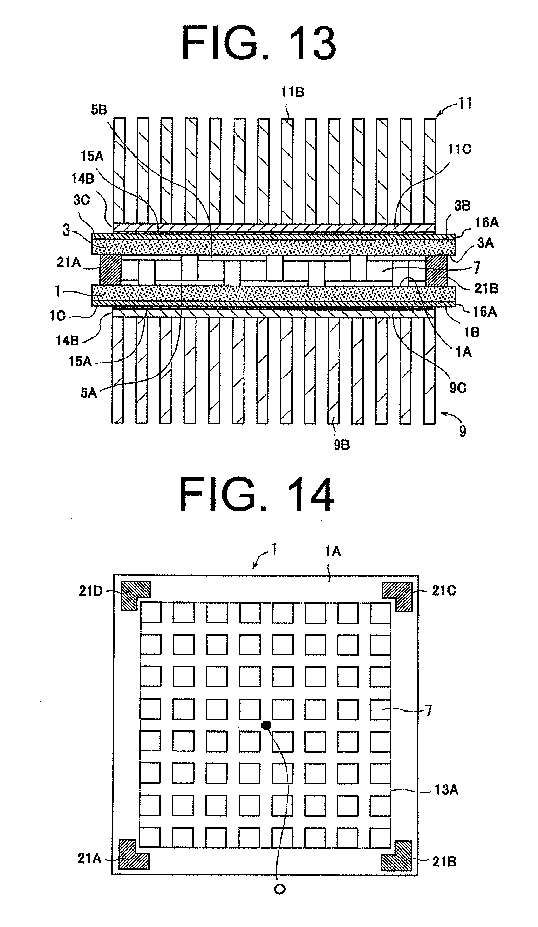

The thermoelectric conversion module according to the seventh embodiment shown in FIGS. 13 and 14, includes column members 21A through 21D which are provided between the first inner surface 1A of the first substrate 1 and the second inner surface 3A of the second substrate 3 at positions that are diagonally outward of the thermoelectric conversion element disposition area 13A located at four corners in the thermoelectric conversion element disposition area 13A. As shown in FIG. 14, the column members 21A through 21D are L-shaped as seen in plan view and provided in such an orientation that the L-shape of each column member 21A conforms to the corner of the thermoelectric conversion element disposition area 13A, as shown in FIG. 14. Alternatively, the column members may be provided only at any two positions of 21A, 21B, 21C and 21D.

The column members 21A through 21D are made of a stainless steel and joined at the opposite ends thereof to the first and the second inner surfaces 1A, 3A of the first and the second substrates 1, 3.

The first fin radiator 9 includes the base 9C having the same square shape as the thermoelectric conversion element disposition area 13A, and the plurality of aluminum plates 9B. Similarly, the second fin radiator 11 includes the base 11C and the plurality of aluminum plates 11B (refer to FIG. 11).

As shown in FIG. 13, the brazing filler metal layer 15A is provided between the metal layer 1C and the base 9C. The brazing filler metal layer 15A and the metal layers 1C, 3C serve as the junction material layer. The first fin radiator 9 is thermally joined to the first substrate 1 through the brazing filler metal layer 15A with the center O of the fist fin radiator 9 coinciding with that of the thermoelectric conversion element disposition area 13A. The second fin radiator 11 is joined to the second substrate 3 in the same manner. The rest of the structure including the positional relation between the fin disposition area 14B and the junction material disposition areas 16A, 16B is the same as that of the first embodiment.

In the thermoelectric conversion module according to the seventh embodiment, thermal deformation of the first and the second substrates 1, 3 are corrected by the column members 21A through 21D at positions diagonally outward of the respective corners of the thermoelectric conversion element disposition area 13A, so that the stress applied to the thermoelectric conversion elements 7 due to the thermal deformation of the first and the second substrates 1, 3 is reduced. Therefore, the thermoelectric conversion elements 7 of the thermoelectric conversion module are hardly damaged.

When a plurality of column members such as 21A through 21D is provided so as to join at the opposite ends thereof the first and the second inner surfaces 1A, 3A of the first and the second substrates 1, 3, such structure allows heat to be transferred through the column members 21A through 21D, between the first and the second substrates 1, 3. As a result, there occurs a fear that the performance of the thermoelectric conversion module may be reduced due to the heat bridge phenomenon. In the thermoelectric conversion module according to the seventh embodiment, however, the column members 21A through 21D are provided at four corners of the thermoelectric conversion element disposition area 13A and joined at the opposite ends thereof to the first and the second substrates 1, 3. Thus, the column members are reduced in number with the result that the reduction of the performance of the thermoelectric conversion module due to the heat bridge phenomenon can be restricted. The seventh embodiment offers also the advantages that are described with reference to the first and the fifth embodiments.

Therefore, the thermoelectric conversion module according to the seventh embodiment offers a long serviceable life and a good performance.

Particularly, the column members 21A through 21D which are formed in an L-shape in plan view can be disposed so as to conform to the corners of the thermoelectric conversion element disposition area 13A. Therefore, such disposition allows the column members 21A through 21D to be located at positions closer to the thermoelectric conversion elements 7 than in the case that the column members are formed in another shape in plan view, helping to correct the thermal deformation of the first and the second substrates 1, 3, so that the thermoelectric conversion elements 7 can be protected against damage. Additionally, the provision of the column members 21A through 21D at positions that are outward of the respective corners of the thermoelectric conversion element disposition area 13A can prevent the thermoelectric conversion module from increasing in size.

The material for the column members 21A through 21D should favorably have low thermal conductivity for protecting the column members against the heat bridge phenomenon and also have a proper Young's modulus for preventing the column members from being deformed. The column members 21A through 21D of the seventh embodiment are made of a stainless steel, having a thermal conductivity of about 16W/mK and a Young's modulus of about 200Gpa, so that the heat bridge phenomenon can be prevented and the thermal deformation of the first and the second substrates 1, 3 can be corrected effectively.

In the thermoelectric conversion module according to the eighth embodiment shown in FIG. 15, subsidiary column members 23A through 23D are provided outward of the thermoelectric conversion element disposition area 13A in addition to the column members 21A through 21D. Each of the subsidiary column members 23A through 23D is disposed at intermediate positions between column members 21A and 21B, between the column members 21B and 21C. between the column members 21C and 21D and between the column members 21D and 21A, respectively.

The subsidiary column members 23A through 23D are made of a stainless steel having substantially a square-shape, as seen in plan view, area of which is smaller than that of the column members 21A through 21D. Like the column members 21A through 21D, the subsidiary column members 23A through 23D are joined at the opposite ends thereof to the first and the second inner surfaces 1A, 3A of the first and the second substrates 1, 3. The rest of the structure is the same as that of the first and the seventh embodiments.

In the thermoelectric conversion module according to the eighth embodiment, the thermal deformation of the first and the second substrates 1, 3 can be corrected by the column members 21A through 21D and the subsidiary column members 23A through 23D, so that the thermoelectric conversion elements 7 are less susceptible to damage than the thermoelectric conversion elements of the seventh embodiment.

Additionally, the subsidiary column members 23A through 23D are made of a stainless steel and the area of each of the subsidiary column members 23A through 23D is smaller than that of the column members 21A through 21D, so that the heat bridge phenomenon can be prevented and thermal deformation of the first and the second substrates 1, 3 can be corrected effectively Furthermore, the manufacturing cost of the subsidiary column members 23A through 23D can be reduced, so that the manufacturing cost of the thermoelectric conversion module can be reduced accordingly. The eighth embodiment offers also the advantages that are described with reference to the first and the seventh embodiments.

The present invention is not limited to the above-described first through the eight embodiments, but may be practiced in various ways as exemplified below.

The thermoelectric conversion element disposition area 13A, 13B may have a polygonal shape other than a square shape and an octagon shape.

A corrugated fin having an aluminum plate bent and formed in a wave shape may be used instead of the first and the second fin radiator 9, 11. In this case, some portion of the corrugated fin that is bent so as to extend outward from the first and the second outer surfaces 1B, 3B of the first and the second substrates 1, 3 and other portion of the corrugated fin that is parallel to the first and the second outer surfaces 1B, 3B of the first and the second substrates 1, 3 correspond to the plate 98 and the base 9A of the present invention, respectively.

The thermoelectric conversion modules according to the fifth through the eighth embodiments may dispense with the first and the second fin radiators 9, 11.

The thermoelectric conversion module according to the third embodiment may have metal layers such as 1C, 3C on the first and the second outer surfaces 1B, 3B of the first and the second substrates 1, 3, respectively. In this case, the masking 17 may be preferably disposed on the metal layers 1C, 3C at a position just below or above the thermoelectric conversion elements 7 that are disposed at the respective corners of the thermoelectric conversion element disposition area 13A on the outer surfaces of the metal layers 1C. 3C.

The thermoelectric conversion modules according to the seventh and the eighth embodiments may have only the subsidiary column members 23A through 23D without the column members 21A through 21D.

The thermoelectric conversion modules according to the eighth embodiment may have the column members only at two diagonally opposite positions such as 21A, 21C, as well as the subsidiary column members 23A through 23D.

The subsidiary column members 23A through 23D made of a stainless steel may have a circular or a triangular shape as seen in plan view.

The present invention can be applied to a power-generating device utilizing Seebeck effect of the thermoelectric conversion element other than the thermoelectric conversion module and the air conditioner utilizing Peltier effect of the thermoelectric conversion element.

A thermoelectric conversion module includes two substrates, electrodes, thermoelectric conversion elements provided between the substrates and electrically connected in series via the electrodes, a polygonally-shaped thermoelectric conversion element disposition area provided on inner surface of the substrate wherein the thermoelectric conversion elements are disposed in the thermoelectric conversion element area, a fin radiator provided on outer surface of the substrate and a fin disposition area wherein the fin radiator is disposed in the fin disposition area. The fin disposition area and the thermoelectric conversion element disposition area are located on opposite sides of the substrates so as to overlap each other via the substrate. Part of each of the thermoelectric conversion elements located at least one corner of the thermoelectric conversion element disposition area is located outside the fin disposition area when the fin disposition area is projected on the thermoelectric conversion element disposition area.

## Claims

1. A thermoelectric conversion module comprising:
a first substrate (1) having a first inner surface (1A) and a first outer surface (1B);
a second substrate (3) having a second inner surface (3A) and a second outer surface (3B), wherein the first inner surface (1A) and the second inner surface (3A) face each other;
a plurality of electrodes (5A, 5B) provided on the first and the second inner surfaces (5A, 5B);
a plurality of thermoelectric conversion elements (7) electrically connected in series via the electrodes (5A, 5B);
a polygonally-shaped thermoelectric conversion element disposition area (13A, 13B) provided on the first and the second inner surfaces (1A, 1B), wherein the thermoelectric conversion elements (7) are disposed in the thermoelectric conversion element area (13A, 13B);
a fin radiator (7, 9) that is provided on at least one of the first and the second outer surfaces (1B, 3B) and has a plurality of plates (11B) extending outward; and
a fin disposition area (14A, 14B) provided on at least one of the first and the second outer surfaces (1B, 3B), wherein the fin radiator (7, 9) is disposed in the fin disposition area (14A, 14B), **characterized in that** the fin disposition area (14A, 14B) and the thermoelectric conversion element disposition area (13A, 13B) are located on opposite sides of at least one of the first and the second substrates (1, 3) so as to overlap each other via at least one of the first and the second substrates (1, 3), wherein the fin disposition area (14A, 14B) is formed so that part of each of the thermoelectric conversion elements (7) located at least one corner of the thermoelectric conversion element disposition area (13A, 13B) is located outside the fin disposition area (14A, 14B) when the fin disposition area (14A) is projected on the thermoelectric conversion element disposition area (13A).

2. The thermoelectric conversion module according to claim 1, **characterized in that** part of each of the thermoelectric conversion elements (7) located at all corners of the thermoelectric conversion element disposition area (13A, 13B) are located outside the fin disposition area (14A, 14B) when the fin disposition area (14A) is projected on the thermoelectric conversion element disposition area (13A).

3. A thermoelectric conversion module comprising:
a first substrate (1) having a first inner surface (1A) and a first outer surface (1B);
a second substrate (3) having a second inner surface (3A) and a second outer surface (3B), wherein the first inner surface (1A) and the second inner surface (3A) face each other;
a plurality of electrodes (5A, 5B) provided on the first and the second inner surfaces (5A, 5B);
a plurality of thermoelectric conversion elements (7) electrically connected in series via the electrodes (5A, 5B);
a polygonally-shaped thermoelectric conversion element disposition area (13A, 13B) provided on the first and the second inner surfaces (1A, 1B), wherein the thermoelectric conversion elements (7) are disposed in the thermoelectric conversion element area (13A, 13B);
a fin radiator (7, 9) that is provided on at least one of the first and the second outer surfaces (1B, 3B) and has a plurality of plates (11B) extending outward;
a junction material layer (1C, 1D, 1E, 15A, 15B, 15C) disposed between the fin radiator (7, 9) and at least one of the first and the second outer surfaces (1B, 3B); and
a junction material layer disposition area (16A, 16B, 16C, 16D, 16E) provided on at least one of the first and the second outer surfaces (1B, 3B), wherein the junction material layer (1C, 1D, 1E, 15A, 15B, 15C) is disposed in the junction material layer disposition area (16A, 16B, 16C, 16D, 16E), **characterized in that** the junction material layer disposition area (16A, 16B, 16C, 16D, 16E) and the thermoelectric conversion element disposition area (13A, 13B) are located on opposite sides of at least one of the first and the second substrates (1, 3) so as to overlap each other via at least one of the first and the second substrates (1, 3), wherein the junction material layer disposition area (16A, 16B, 16C, 16D, 16E) is formed so that part of each of the thermoelectric conversion elements (7) located at least one corner of the thermoelectric conversion element disposition area (13A, 13B) is located outside the junction material layer disposition area (16A, 16B, 16C, 16D, 16E) when the junction material layer disposition area (16A, 16B, 16C, 16D, 16E) is projected on the thermoelectric conversion element disposition area (13A).

4. The thermoelectric conversion module according to claim 3, **characterized in that** part of the thermoelectric conversion elements (7) provided at all corners of the thermoelectric conversion element disposition area (13A, 13B) are located outside the junction material layer (1C, 1D, 1E, 15A, 15B, 15C) when the junction material layer disposition area (16A, 16B, 16C, 16D, 16E) is projected on the thermoelectric conversion element disposition area (13A).

5. The thermoelectric conversion module according to 2 or 4, **characterized in that** the thermoelectric conversion element disposition area (13A, 13B) is rectangular-shaped and the fin disposition area (14A, 14B) or the junction material layer (1C, 1D, 1E, 15A, 15B, 15C) is octagonal-shaped.

6. A thermoelectric conversion module comprising:
a first substrate (1) having a first inner surface (1A) and a first outer surface (1B);
a second substrate (3) having a second inner surface (3A) and a second outer surface (3B), wherein the first inner surface (1A) and the second inner surface (3A) face each other;
a plurality of electrodes (5A, 5B) provided on the first and the second inner surfaces (5A, 5B);
a plurality of thermoelectric conversion elements (7) electrically connected in series via the electrodes (5A, 5B);
a polygonally-shaped thermoelectric conversion element disposition area (13A, 13B) provided on the first and the second inner surfaces (1A, 1B), wherein the thermoelectric conversion elements (7) are disposed in the thermoelectric conversion element area (13A, 13B); and
a fin radiator (7, 9) including a base (9A, 9C, 9D, 11A, 11C, 11D) extending in parallel to at least one of the first and the second outer surfaces (1B, 3B) and a plurality of plates (9B, 11B) extending outward from at least one of the first and the second outer surfaces (1B, 3B), **characterized in that** the base (9A, 9C, 9D, 11A, 11C, 11D) and at least one of the first and the second outer surfaces (1B, 3B) cooperate to form a space (19) at a position corresponding to at least one of corners of the thermoelectric conversion element disposition area (13A, 13B).

7. The thermoelectric conversion module according to claim 6, **characterized in that** the base (9A, 9C, 9D, 11A, 11C, 11D) and at least one of the first and the second outer surfaces (1B, 3B) cooperate to form spaces (19) at positions corresponding to all corners of the thermoelectric conversion element disposition area (13A, 13B).

8. A thermoelectric conversion module comprising:
a first substrate (1) having a first inner surface (1A) and a first outer surface (1B);
a second substrate (3) having a second inner surface (3A) and a second outer surface (3B), wherein the first inner surface (1A) and the second inner surface (3A) face each other;
a plurality of electrodes (5A, 5B) provided on the first and the second inner surfaces (5A, 58);
a plurality of thermoelectric conversion elements (7) electrically connected in series via the electrodes (5A, 5B); and
a polygonally-shaped thermoelectric conversion element disposition area (13A, 13B) provided on the first and the second inner surfaces (1A, 1B), wherein the thermoelectric conversion elements (7) are disposed in the thermoelectric conversion element disposition area (13A, 13B), **characterized in that** each inner angle of all corners of the thermoelectric conversion element disposition area (13A, 13B) is more than 90°.

9. The thermoelectric conversion module according to claim 8, **characterized in that** the thermoelectric conversion element disposition area (13A, 13B) has a pentagonal shape.-or
an octagonal shape, and/or
further comprising:
a fin radiator (7, 9) having a plurality of plates (11B) extending outward from at least one of the first and the second outer surfaces (1B, 3B); and
a fin disposition area (14A, 14B) provided on at least one of the first and the second outer surfaces (1B, 3B) so that the fin disposition area (14A, 14B) and the thermoelectric conversion element disposition area (13A, 13B) overlap each other when the fin disposition area (14A, 14B) is projected on the thermoelectric conversion element disposition area (13A), wherein the fin radiator (7, 9) is disposed in the fin disposition area (14A, 14B), **characterized in that** the thermoelectric conversion element disposition area (13, 13A, 13B) is rectangular-shaped, and/or
the first and the second substrates (1, 3) are rectangular-shaped, wherein center (O) of the thermoelectric conversion element disposition area (13A, 13B) coincides with that of the first and the second substrates (1, 3).

10. A thermoelectric conversion module comprising:
a first substrate (1) having a first inner surface (1A) and a first outer surface (1B);
a second substrate (3) having a second inner surface (3A) and a second outer surface (3B), wherein the first inner surface (1A) and the second inner surface (3A) face each other;
a plurality of electrodes (5A, 5B) provided on the first and the second inner surfaces (5A, 5B);
a plurality of thermoelectric conversion elements (7) electrically connected in series via the electrodes (5A, 5B),
a polygonally-shaped thermoelectric conversion element disposition area (13A, 13B) provided on the first and the second inner surfaces (1A, 1B), wherein the thermoelectric conversion elements (7) are disposed in the thermoelectric conversion element area (13A, 13B); and
a plurality of column member (21A, 21B, 21C, 21D), **characterized in that** the column member (21A, 21B, 21C, 21D) are provided between the first and the second substrates (1, 3) at positions that are outward of the thermoelectric conversion element disposition area (13A, 13B) and joined to the first and the second substrates (1, 3).

11. The thermoelectric conversion module according to claim 10, **characterized in that** the column members (21A, 21B, 21C, 21D) are provided at positions that are outward of at least two corners of the thermoelectric conversion element disposition area (13A, 13B).

12. The thermoelectric conversion module according to claim 11, **characterized in that** the column members (21A, 21B, 21C, 21D) are provided at positions that are outward of all corners of the thermoelectric conversion element disposition area (13A, 13B).

13. The thermoelectric conversion module according to any one of claims 10 through 12, **characterized in that** the column member (21A, 21B, 21C, 21D) is substantially L-shaped in cross-section that is parallel to the first and the second substrates (1, 3), and/or the column member (21A, 21B, 21C, 21D) is made of a stainless steel.

14. The thermoelectric conversion module according to claim 10, further comprising:
A subsidiary column member (23A, 23B, 23C, 23D), **characterized in that** the subsidiary column member (23A, 238, 23C, 23D) is provided between the first and the second substrates (1, 3) at a position that is outward of the thermoelectric conversion element disposition area (13A, 13B) and joined to the first and the second substrates (1, 3), wherein the column members (21A, 21B, 21C, 21D) are provided at least two positions, wherein the subsidiary column member (23A, 23B, 23C, 23D) is provided between at least one of any two adjacent column members (23A, 23B, 23C, 23D).

15. The thermoelectric conversion module according to claim , 14, **characterized in that** cross-section of the subsidiary column member (23A, 23B, 23C, 23D) is smaller than that of the column members (21A, 21B, 21C, 21D), wherein the cross-section is parallel to the first and the second substrates (1, 3), and/or the subsidiary column member (23A, 23B, 23C, 23D) is made of a stainless steel.

16. The thermoelectric conversion module according to any one of claims 10 and 15, **characterized in that** the thermoelectric conversion element disposition area (13, 13A, 13B) is rectangular-shaped,
